# EUROPÄISCHE PATENTSCHRIFT

(11) **EP 3 021 434 B1**
(45) Veröffentlichungstag und Bekanntmachung des Hinweises auf die Patenterteilung: **11.01.2017**
(21) Anmeldenummer: 14192908.3
(22) Anmeldetag: 12.11.2014
(51) Int. Cl.: H02B 1/052

(54) **Vorrichtung und Verfahren zur werkzeuglosen Montage von Modulen an eine Hutschiene**
Device and method for the tool-less mounting of modules on a din rail
Dispositif et procédé pour la montage sans outil de modules sur un profilé chapeau

(43) Veröffentlichungstag der Anmeldung: 18.05.2016
(73) Patentinhaber: SKIDATA AG, 5083 Grödig/Salzburg (AT)
(72) Erfinder: Schieren, Jürgen, 80637 München (DE)
(74) Vertreter: Karakatsanis, Georgios

(56) Entgegenhaltungen:
- DE-A1- 1 590 115
- DE-C- 932 847

## Beschreibung

Die vorliegende Erfindung bezieht sich auf eine Vorrichtung zur werkzeuglosen Montage von Modulen an eine Hutschiene und zur zerstörungsfreien, werkzeuglosen Demontage derselben gemäß dem Oberbegriff des Patentanspruchs 1. Des Weiteren bezieht sich die Erfindung auf ein Verfahren zur werkzeuglosen Montage von Modulen an eine Hutschiene und zur zerstörungsfreien, werkzeuglosen Demontage derselben mittels der erfindungsgemäßen Vorrichtung.

Aus dem Stand der Technik ist bekannt, zur Anordnung von Modulen, insbesondere elektrischen und elektronischen Modulen innerhalb eines Gehäuses sogenannte Hutschienen zu verwenden, an die die Module montiert werden. Hutschienen sind Profilschienen, die z.B. zur Befestigung von Modulen in Verteilerkästen, Schaltschränken, Verkaufsautomaten etc. verwendet werden. Oft steht jedoch innerhalb eines Gerätes, in dem eine Hutschiene angeordnet ist, außer dem Bauraum für ein Modul kaum Raum für die Montage, insbesondere für Montagewerkzeuge zur Verfügung.

Aus der DE 932847 C ist eine Anreihklemme für elektrische Leitungen bekannt, die mittels eines federnden Gliedes auf einer Tragschiene gehalten ist, bei der das federnde Halteglied aus einer Schraubenfeder besteht, welche in der Mitte eine angebogene, gerade Schlaufe bzw. Nase aufweist und an ihren beiden äußeren Enden in je einen Schenkel ausläuft.

Ferner geht aus der DE 15 90 115 A eine Befestigungsvorrichtung für auf einer Gerätebank angeordnete elektrische Bauelemente, insbesondere Schütze kleinerer oder mittlerer Größe hervor, bei der federnde Drahtklammern zur schraubenlosen Befestigung der Bauelemente dienen, die auf der einen Seite in Befestigungslöcher der Bauelemente eingreifen und sich auf der anderen Seite an den Kanten der Gerätebank hintergriffig abstützen.

Der vorliegenden Erfindung liegt die Aufgabe zugrunde, eine Vorrichtung zur werkzeuglosen Montage von Modulen an eine Hutschiene und zur zerstörungsfreien, werkzeuglosen Demontage derselben anzugeben, durch deren Verwendung ein Modul schnell und zuverlässig auch auf engsten Raum montiert und demontiert werden kann. Ferner soll ein Verfahren zur werkzeuglosen Montage von Modulen an eine Hutschiene und zur zerstörungsfreien, werkzeuglosen Demontage derselben mittels der erfindungsgemäßen Vorrichtung angegeben werden.

Diese Aufgabe wird für eine Vorrichtung durch die Merkmale des Patentanspruchs 1 gelöst. Ein Verfahren ist Gegenstand des Anspruchs 3. Weitere Vorteile und Ausgestaltungen gehen aus den Unteransprüchen hervor.

Demnach wird eine Vorrichtung zur werkzeuglosen Montage von Modulen an eine Hutschiene und zur zerstörungsfreien, werkzeuglosen Demontage derselben vorgeschlagen, welche als vorzugsweise einstückige Doppelschenkelfeder ausgeführt ist, mit einer ersten Schenkelfeder und einer zweiten Schenkelfeder, die koaxial zu einer gemeinsamen Federachse angeordnet sind, wobei an einem ersten Ende der Doppelschenkelfeder ein Federende der ersten Schenkelfeder einen ersten Federschenkel und ein Federende der zweiten Schenkelfeder einen zweiten Federschenkel bilden, wobei der erste und zweite Federschenkel gleich dimensioniert sind und jeweils einen in Richtung des anderen, zweiten Endes der Doppelschenkelfeder gebogenen Haken bilden. Die Doppelschenkelfeder weist am anderen, zweiten Ende einen gemeinsamen Zwischenschenkel auf, der einen in Richtung des ersten Endes gebogenen Haken bildet.

Die Haken am ersten Ende der Doppelschenkelfeder und der durch den Zwischenschenkel gebildete Haken am zweiten Ende der Doppelschenkelfeder ragen aus einer durch die zwischen den Schenkelfedern und dem gemeinsamen Zwischenschenkel befindlichen geraden Teile der Doppelschenkelfeder gebildeten Ebene an derselben Seite heraus, wobei die beiden Schenkelfedern an der entgegengesetzten Seite aus dieser Ebene herausragen. Die Schenkelfedern sind derart ausgeführt, dass die Haken am ersten Ende der Doppelschenkelfeder und der durch den Zwischenschenkel gebildete Haken am zweiten Ende der Doppelschenkelfeder gegen die Kraft der Schenkelfedern auseinandergezogen werden können.

Zur Montage eines Moduls mittels der erfindungsgemäßen Vorrichtung an einer Hutschiene wird zunächst im Rahmen einer Vormontage die Vorrichtung an das zu montierenden Modul befestigt.

Hierbei werden die beiden Schenkelfedern sowie der erste und zweite Federschenkel mit den Schenkelfedern voran jeweils durch eine erste und zweite Öffnung an der der im montierten Zustand der Hutschiene zugewandten Gehäusewand des Moduls geführt, wobei die beiden durch den ersten und zweiten Federschenkel gebildeten Haken jeweils in eine dritte und vierte Öffnung der im montierten Zustand der Hutschiene zugewandten Gehäusewand des Moduls oberhalb der ersten und zweiten Öffnung von der der Hutschiene im montierten Zustand abgewandten Seite der Gehäusewand eingehängt werden.

Nach dem Einhängen der durch den ersten und zweiten Federschenkel gebildeten Haken ragt der durch den Zwischenschenkel gebildete Haken aus der im montierten Zustand der Hutschiene zugewandten Seite der im montierten Zustand der Hutschiene zugewandten Gehäusewand des Moduls heraus, da die zwischen der ersten und zweiten Öffnung befindliche Gehäusewand eine Bewegung des Hakens in Richtung des Gehäuseinneren verhindert.

Anschließend wird im Rahmen des eigentlichen Montageschrittes, bei dem das Modul an die Hutschiene angebracht wird, zuerst ein Formschluss zwischen dem durch den Zwischenschenkel gebildeten Haken und dem unteren Ende der Hutschiene hergestellt, wobei anschließend das Modul gegen die Kraft der Schenkelfedern nach oben gezogen und in Richtung der Hutschiene gedrückt wird, bis ein nach unten, d.h. in Richtung des Zwischenschenkels gebogener Vorsprung der der Hutschiene zugewandten Gehäusewand des Moduls mit dem oberen Ende der Hutschiene eine formschlüssige Verbindung herstellt. Das Modul wird durch die Kraft der Schenkelfedern nach unten gezogen, so dass die formschlüssige Verbindung zwischen dem Vorsprung und dem oberen Ende der Hutschiene ohne gezielte äußere Einwirkung nicht gelöst werden kann, wodurch das Modul an der Hutschiene montiert ist.

In vorteilhafter Weise wirkt im montierten Zustand keine oder nur eine sehr geringe Kraft auf die Doppelschenkelfeder, da das Gewicht von der formschlüssigen Verbindung zwischen der Hutschiene und dem nach unten gebogenen Vorsprung des Moduls getragen wird und der durch den Zwischenschenkel gebildete Haken mittels der formschlüssigen Verbindung mit dem unteren Ende der Hutschiene der Fixierung des Moduls dient. Zur Demontage wird in umgekehrter Reihenfolge vorgegangen, so dass die Verbindung zerstörungsfrei und werkzeuglos lösbar ist.

Durch die erfindungsgemäße Konzeption wird bei geringen Herstellungskosten der Montageaufwand erheblich reduziert. Da kein Werkzeug benötigt wird, ist eine Montage auch im engsten Raume durch einfache Bewegungen des Moduls mit der vormontierten Doppelschenkelfeder möglich.

Die Erfindung wird im Folgenden anhand der beigefügten Figuren beispielshaft näher erläutert. Es zeigen:
- Figur 1: eine perspektivische Ansicht einer erfindungsgemäßen Vorrichtung;
- Figur 2: eine perspektivische schematische Ansicht eines Teiles des Gehäuses eines zu montierenden Moduls mit einer vormontierten erfindungsgemäßen Vorrichtung;
- Figur 3: einen nächsten Schritt des erfindungsgemäßen Montageverfahrens;
- Figur 4: einen nächsten Schritt des erfindungsgemäßen Montageverfahrens;
- Figur 5: einen nächsten Schritt des erfindungsgemäßen Montageverfahrens; und
- Figur 6: eine schematische Seitenansicht eines mittels einer erfindungsgemäßen Vorrichtung an einer Hutschiene montierten Moduls.

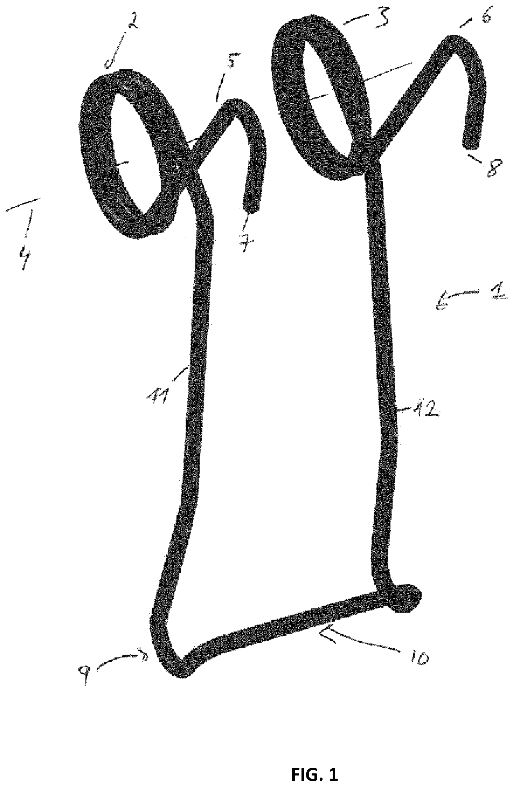

Gemäß der Erfindung und bezugnehmend auf Figur 1 ist die Vorrichtung zur werkzeuglosen Montage von Modulen an eine Hutschiene und zur zerstörungsfreien, werkzeuglosen Demontage derselben als vorzugsweise einstückige Doppelschenkelfeder 1 ausgeführt, mit einer ersten Schenkelfeder 2 und einer zweiten Schenkelfeder 3, die koaxial zu einer gemeinsamen Federachse 4 angeordnet sind, wobei an einem ersten, bei den in den Figuren gezeigten Beispielen im montierten Zustand oberen Ende der Doppelschenkelfeder 1 ein Federende der ersten Schenkelfeder 2 einen ersten Federschenkel 5 und ein Federende der zweiten Schenkelfeder 3 einen zweiten Federschenkel 6 bilden, wobei der erste und zweite Federschenkel 5, 6 gleich dimensioniert sind und jeweils einen in Richtung des anderen, zweiten, bei den in den Figuren gezeigten Beispielen im montierten Zustand unteren Endes der Doppelschenkelfeder 1 gebogenen Haken 7, 8 bilden.

Wie Figur 1 zu entnehmen ist, weist die Doppelschenkelfeder 1 am anderen, zweiten Ende einen gemeinsamen Zwischenschenkel 9 auf, der einen in Richtung des ersten Endes der Doppelschenkelfeder 1 gebogenen Haken 10 bildet.

Der erste und zweite Haken 7, 8 am ersten Ende der Doppelschenkelfeder 1 und der durch den Zwischenschenkel 9 gebildete Haken 10 am zweiten Ende der Doppelschenkelfeder 1 ragen aus einer durch die zwischen den Schenkelfedern 2, 3 und dem gemeinsamen Zwischenschenkel 9 befindlichen geraden Teile 11, 12 der Doppelschenkelfeder 1 gebildeten Ebene an derselben Seite heraus, wobei die beiden Schenkelfedern 2, 3 an der entgegengesetzten Seite aus dieser Ebene herausragen. Ferner sind die Schenkelfedern 2, 3 derart ausgeführt, dass die Haken 7, 8 am ersten Ende der Doppelschenkelfeder 1 und der durch den Zwischenschenkel 9 gebildete Haken 10 am zweiten Ende der Doppelschenkelfeder 1 gegen die Kraft der Schenkelfedern 2, 3 auseinandergezogen werden können.

Vorzugsweise ist die erfindungsgemäße Doppelschenkelfeder 1 aus Federstahl hergestellt, wobei die Dimensionierung und Auslegung der Doppelschenkelfeder 1 entsprechend dem Gewicht und der Dimensionierung des zu montierenden Moduls ausgewählt werden.

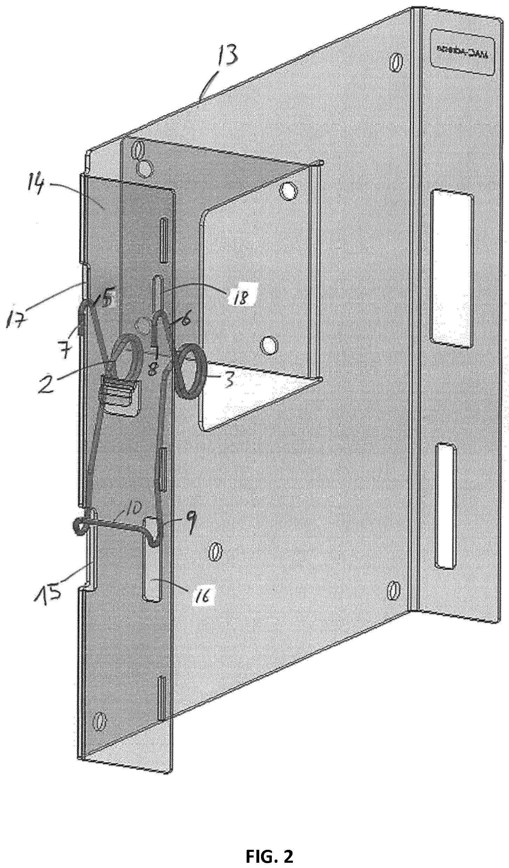

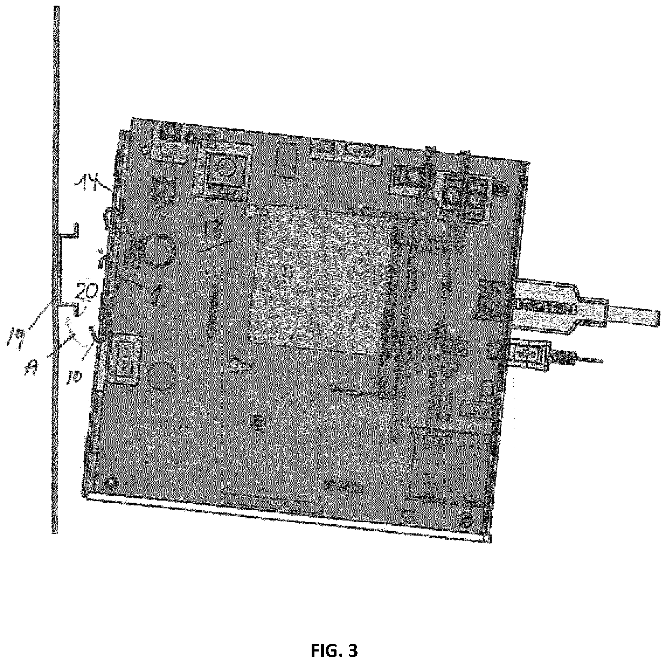

Die Montage eines Moduls 13 mittels der erfindungsgemäßen Doppelschenkelfeder 1 wird anhand Figuren 2-6 veranschaulicht. Um das Verständnis zu erleichtern, wird ein Teil des Gehäuses des Moduls 13 dargestellt, wobei die im montierten Zustand der Hutschiene zugewandte Gehäusewand 14 transparent dargestellt ist. In Figuren 3-6 sind elektronische Komponenten des Moduls 13 schematisch dargestellt.

In einem ersten Schritt wird die Doppelschenkelfeder 1 an das zu montierenden Modul 13 befestigt, wobei die beiden Schenkelfedern 2, 3 sowie der erste und zweite Federschenkel 5, 6 mit den Schenkelfedern 2, 3 voran jeweils durch eine erste und zweite Öffnung 15, 16 an der der Hutschiene im montierten Zustand zugewandten Seite der im montierten Zustand der Hutschiene zugewandten Gehäusewand 14 des Moduls 13 geführt, wobei die beiden durch den ersten und zweiten Federschenkel 5, 6 gebildeten Haken 7, 8 jeweils in eine dritte und vierte Öffnung 17, 18 der im montierten Zustand der Hutschiene zugewandten Gehäusewand 14 des Moduls 13 im montierten Zustand betrachtet oberhalb der ersten und zweiten Öffnung 15, 16 von der der Hutschiene im montierten Zustand abgewandten Seite der Gehäusewand 14 eingehängt werden.

Nach dem Einhängen der durch den ersten und zweiten Federschenkel 5, 6 gebildeten Haken 7, 8 ragt der durch den Zwischenschenkel 9 gebildete Haken 10 aus der im montierten Zustand der Hutschiene zugewandten Seite der im montierten Zustand der Hutschiene zugewandten Gehäusewand 14 des Moduls 13 heraus, da der zwischen der ersten und zweiten Öffnung 15, 16 befindliche Teil der Gehäusewand 14 eine Bewegung des Hakens 10 in Richtung des Gehäuseinneren verhindert.

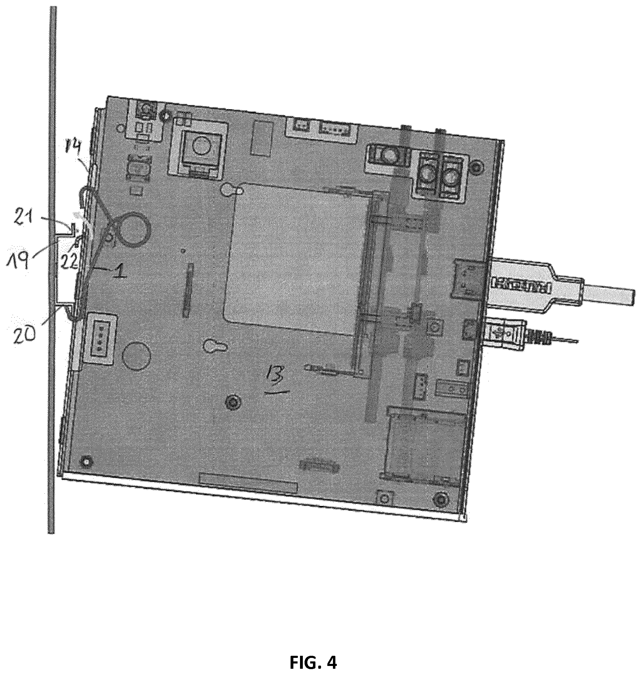

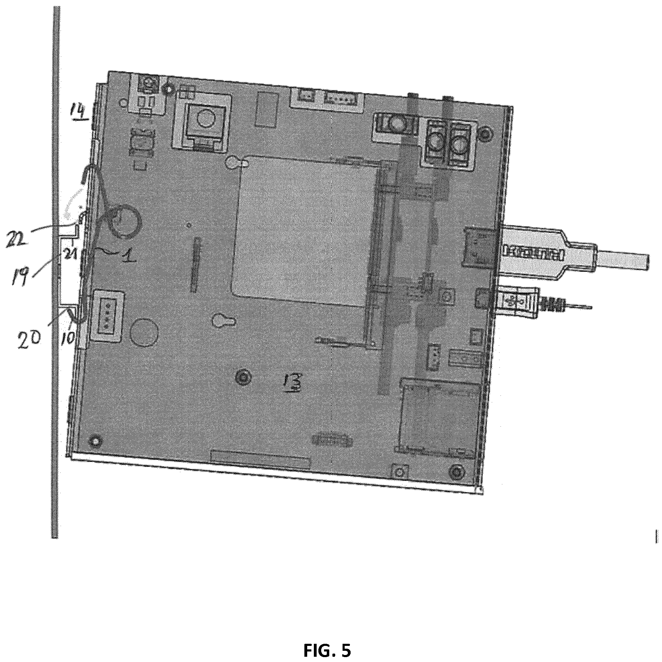

In einem nächsten Schritt wird das Modul 13 an die Hutschiene 19 angebracht, indem wie anhand Figur 3 durch den Pfeil A veranschaulicht, zuerst ein Formschluss zwischen dem durch den Zwischenschenkel 9 gebildeten Haken 10 und dem unteren Ende 20 der Hutschiene 19 hergestellt wird, wobei anschließend und bezugnehmend auf Figuren 4 und 5 das Modul 13 gegen die Kraft der Schenkelfedern 2, 3 nach oben gezogen und in Richtung der Hutschiene 19 gedrückt wird, bis ein nach unten, d.h. in Richtung des Zwischenschenkels 9 gebogener Vorsprung 22 der der Hutschiene 19 im montierten Zustand zugewandten Seite der im montierten Zustand der Hutschiene zugewandten Gehäusewand 14 des Moduls 13 mit dem oberen Ende 21 der Hutschiene 19 eine formschlüssige Verbindung herstellt.

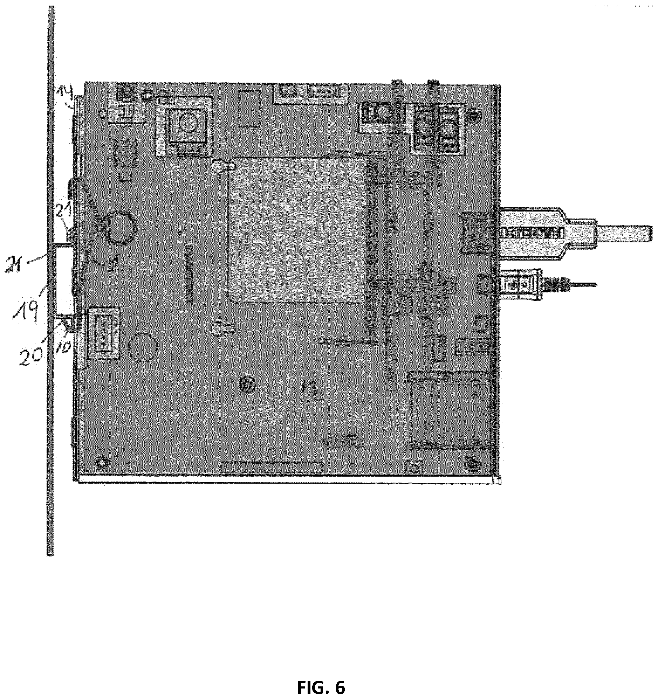

Das Modul wird durch die Kraft der Schenkelfedern 2, 3 nach unten gezogen, so dass die formschlüssige Verbindung zwischen dem Vorsprung 22 und dem oberen Ende der Hutschiene 19 ohne gezielte äußere Einwirkung nicht gelöst werden kann, wodurch das Modul 13 an der Hutschiene 19 montiert ist, wie anhand Figur 6 dargestellt.

Die Demontage des Moduls 13 erfolgt in umgekehrter Reihenfolge.

Die Position der Öffnungen 15, 16, 17, 18 und des Vorsprungs 22 der der Hutschiene 19 im montierten Zustand zugewandten Seite der im montierten Zustand der Hutschiene 19 zugewandten Gehäusewand 14 des Moduls 13 und die Dimensionierung der Doppelschenkelfeder 1 sind aufeinander abgestimmt, um die Montage zu ermöglichen.

Bei dem gezeigten Beispiel wirkt in vorteilhafter Weise im montierten Zustand keine oder nur eine sehr geringe Kraft auf die Doppelschenkelfeder 1, da das Gewicht von der formschlüssigen Verbindung zwischen der Hutschiene 19 und dem nach unten gebogenen Vorsprung 22 der im montierten Zustand der Hutschiene 19 zugewandten Gehäusewand 14 des Moduls 13 getragen wird und der durch den Zwischenschenkel 9 gebildete Haken 10 mittels der formschlüssigen Verbindung mit dem unteren Ende 20 der Hutschiene 19 der Fixierung des Moduls 13 dient.

Alternativ können die Doppelschenkelfeder 1 und das Modul oder die im montierten Zustand der Hutschiene 19 zugewandte Gehäusewand 14 des Moduls 13 um 180° relativ zur Hutschiene 19 gedreht montiert werden, wobei in diesem Fall das Gewicht von dem durch den Zwischenschenkel 9 gebildeten Haken 10, der mit dem oberen Ende 21 der Hutschiene 19 formschlüssig verbunden ist, getragen wird und eine formschlüssige Verbindung im unteren Bereich zwischen dem Vorsprung 22 der im montierten Zustand der Hutschiene zugewandten Gehäusewand 14 des Moduls 13 und dem unteren Ende der Hutschiene 19 der Fixierung des Moduls 13 dient.

## Patentansprüche

1. Vorrichtung zur werkzeuglosen Montage von Modulen (13) an eine Hutschiene (19) und zur zerstörungsfreien, werkzeuglosen Demontage derselben, **dadurch gekennzeichnet, dass** sie als Doppelschenkelfeder (1) ausgeführt ist, mit einer ersten Schenkelfeder (2) und einer zweiten Schenkelfeder (3), die koaxial zu einer gemeinsamen Federachse (4) angeordnet sind, wobei an einem ersten Ende der Doppelschenkelfeder (1) ein Federende der ersten Schenkelfeder (2) einen ersten Federschenkel (5) und ein Federende der zweiten Schenkelfeder (3) einen zweiten Federschenkel (6) bilden, wobei der erste und zweite Federschenkel (5, 6) gleich dimensioniert sind und jeweils einen in Richtung eines anderen, zweiten Endes der Doppelschenkelfeder (1) gebogenen Haken (7, 8) bilden, wobei die Doppelschenkelfeder (1) am anderen, zweiten Ende einen gemeinsamen Zwischenschenkel (9) aufweist, der einen in Richtung des ersten Endes gebogenen Haken (10) bildet, wobei der erste und zweite Haken (7, 8) am ersten Ende der Doppelschenkelfeder (1) und der durch den Zwischenschenkel (9) gebildete Haken (10) am zweiten Ende der Doppelschenkelfeder (1) aus einer durch die zwischen den Schenkelfedern (2, 3) und dem gemeinsamen Zwischenschenkel (9) befindlichen geraden Teile (11, 12) der Doppelschenkelfeder (1) gebildeten Ebene an derselben Seite herausragen, wobei die beiden Schenkelfedern (2, 3) an der entgegengesetzten Seite aus dieser Ebene herausragen und wobei die Schenkelfedern (2, 3) derart ausgeführt sind, dass die Haken (7, 8) am ersten Ende
der Doppelschenkelfeder (1) und der durch den Zwischenschenkel (9) gebildete Haken (10) am zweiten Ende der Doppelschenkelfeder (1) gegen die Kraft der Schenkelfedern (2, 3) auseinandergezogen werden können, wobei die beiden Schenkelfedern (2, 3) und der erste und zweite Federschenkel (5, 6) mit den Schenkelfedern (2, 3) voran jeweils durch eine erste und zweite Öffnung (15, 16) an der der im montierten Zustand der Hutschiene (19) zugewandten Gehäusewand (14) des Moduls (13) führbar sind und wobei die beiden durch den ersten und zweiten Federschenkel (5, 6) gebildeten Haken (7, 8) jeweils in eine dritte und vierte Öffnung (17, 18) der im montierten Zustand der Hutschiene (19) zugewandten Gehäusewand (14) des Moduls (13) oberhalb der ersten und zweiten Öffnung (15, 16) von der der Hutschiene (19) im montierten Zustand abgewandten Seite der Gehäusewand (14) einhängbar sind.

2. Vorrichtung zur werkzeuglosen Montage von Modulen (13) an eine Hutschiene (19) und zur zerstörungsfreien, werkzeuglosen Demontage derselben nach Anspruch 1, **dadurch gekennzeichnet, dass** die Doppelschenkelfeder (1) aus Federstahl hergestellt ist.

3. Verfahren zur werkzeuglosen Montage von Modulen (13) an eine Hutschiene (19) und zur zerstörungsfreien, werkzeuglosen Demontage derselben mittels einer Vorrichtung gemäß Anspruch 1 oder 2, umfassend folgende Schritte:
Befestigen der Doppelschenkelfeder (1) an das zu montierende Modul (13), wobei die beiden Schenkelfedern (2, 3) sowie der erste und zweite Federschenkel (5, 6) mit den Schenkelfedern (2, 3) voran jeweils durch eine erste und zweite Öffnung (15, 16) an der der Hutschiene (19) im montierten Zustand zugewandten Seite der im montierten Zustand der Hutschiene (19) zugewandten Gehäusewand (14) des Moduls (13) geführt werden, wobei die beiden durch den ersten und zweiten Federschenkel (5, 6) gebildeten Haken (7, 8) jeweils in eine dritte und vierte Öffnung (17, 18) der im montierten Zustand der Hutschiene zugewandten Gehäusewand (14) des Moduls (13) im montierten Zustand betrachtet oberhalb der ersten und zweiten Öffnung (15, 16) von der der Hutschiene (19) im montierten Zustand abgewandten Seite der Gehäusewand (14) eingehängt werden, wobei nach dem Einhängen der durch den ersten und zweiten Federschenkel (5, 6) gebildeten Haken (7, 8) der durch den Zwischenschenkel (9) gebildete Haken (10) aus der im montierten Zustand der Hutschiene (19) zugewandten Seite der im montierten Zustand der Hutschiene (19) zugewandten Gehäusewand (14) des Moduls (13) herausragt; und
Anbringen des Moduls (13) an die Hutschiene (19), indem zuerst ein Formschluss zwischen dem durch den Zwischenschenkel (9) gebildeten Haken (10) und dem unteren Ende (20) der Hutschiene (19) hergestellt wird, wobei anschließend das Modul (13) gegen die Kraft der Schenkelfedern (2, 3) nach oben gezogen und in Richtung der Hutschiene (19) gedrückt wird, bis ein nach unten, d.h. in Richtung des Zwischenschenkels (9) gebogener Vorsprung (22) der der Hutschiene (19) im montierten Zustand zugewandten Seite der im montierten Zustand der Hutschiene (19) zugewandten Gehäusewand (14) des Moduls (13) mit dem oberen Ende (21) der Hutschiene (19) eine formschlüssige Verbindung herstellt, wobei das Modul (13) durch die Kraft der Schenkelfedern (2, 3) nach unten gezogen wird, so dass die formschlüssige Verbindung zwischen dem Vorsprung (22) und dem oberen Ende (21) der Hutschiene (19) ohne gezielte äußere Einwirkung nicht gelöst werden kann, wodurch das Modul (13) an der Hutschiene (19) montiert ist.

## Claims

1. Device for the tool-free mounting of modules (13) on a top hat rail (19) and for the nondestructive, tool-free dismounting thereof, **characterized in that** the device is realized in the form of a double torsion spring (1) with a first torsion spring (2) and a second torsion spring (3), which are arranged coaxial to a common spring axis (4), wherein a spring end of the first torsion spring (2) forms a first spring leg (5) and a spring end of the second torsion spring (3) forms a second spring leg (6) on a first end of the double torsion spring (1), wherein the first and the second spring leg (5, 6) are dimensioned identical and respectively form a hook (7, 8), which is bent in the direction of the other, second end of the double torsion spring (1), wherein the double torsion spring (1) features on the other, second end a common intermediate leg (9), which forms a hook (10) bent in the direction of the first end, wherein the first and second hook (7, 8) on the first end of the double torsion spring (1) and the hook (10) formed by the intermediate leg (9) on the second end of the double torsion spring (1) protrude from a plane, which is defined by the straight sections (11, 12) of the double torsion spring (1) located between the torsion springs (2, 3) and the common intermediate leg (9), on the same side, wherein the two torsion springs (2, 3) protrude from this plane on the opposite side and the torsion springs (2, 3) are realized in such a way that the hooks (7, 8) on the first end of the double torsion spring (1) and the hook (10) formed by the intermediate leg (9) on the second end of the double torsion spring (1) can be pulled apart from one another against the force of the torsion springs (2, 3), wherein the two torsion springs (2, 3) and the first and the second spring leg (5, 6) can be respectively guided, with the torsion springs (2, 3) at the front, through a first and a second opening (15, 16) in the housing wall (14) of the module (13) facing the top hat rail (19) in the mounted state, and wherein the two hooks (7, 8) formed by the first and the second spring leg (5, 6) can be respectively hooked into a third and a fourth opening (17, 18), which are arranged above the first and the second opening (15, 16) in the housing wall (14) of the module (13) facing the top hat rail (19) in the mounted state, from the side of the housing wall (14) facing away from the top hat rail (19) in the mounted state.

2. Device for the tool-free mounting of modules (13) on a top hat rail (19) and for the nondestructive, tool-free dismounting thereof according to claim 1, **characterized in that** the double torsion spring (1) is made of spring steel.

3. Method for the tool-free mounting of modules (13) on a top hat rail (19) and for the nondestructive, tool-free dismounting thereof by means of a device according to claim 1 or 2, comprising the steps of:
fastening the double torsion spring (1) on the module (13) to be mounted, wherein the two torsion springs (2, 3) as well as the first and the second spring leg (5, 6) are respectively guided, with the torsion springs (2, 3) at the front, through a first and a second opening (15, 16) in the side of the housing wall (14) of the module (13) facing the top hat rail (19) in the mounted state, which faces the top hat rail (19) in the mounted state, wherein the two hooks (7, 8) formed by the first and the second spring leg (5, 6) are respectively hooked into a third and a fourth opening (17, 18), which are arranged above the first and the second opening (15, 16) in the housing wall (14) of the module (13) facing the top hat rail (19) in the mounted state, from the side of the housing wall (14) facing away from the top hat rail (19) in the mounted state, and wherein the hook (10) formed by the intermediate leg (9) protrudes from the side of the housing wall (14) of the module (13) facing the top hat rail (19) in the mounted state, which faces the top hat rail (19) in the mounted state, after the hooks (7, 8) formed by the first and the second spring leg (5, 6) were respectively hooked into the third and the fourth opening; and
attaching the module (13) to the top hat rail (19) by initially producing a positive fit between the hook (10) formed by the intermediate leg (9) and the lower end (20) of the top hat rail (19), wherein the module (13) is subsequently pulled upward against the force of the torsion springs (2, 3) and pushed in the direction of the top hat rail (19) until a projection (22), which is bent downward, i.e. in the direction of the intermediate leg (9), of the side of the housing wall (14) of the module (13) facing the top hat rail (19) in the mounted state, which faces the top hat rail (19) in the mounted state, produces a positive-fitting connection with the upper end (21) of the top hat rail (19), and wherein the module (13) is pulled downward by the force of the torsion springs (2, 3) such that the positive-fitting connection between the projection (22) and the upper end (21) of the top hat rail (19) cannot be separated without purposeful external influence and the module (13) is thereby mounted on the top hat rail (19).

## Revendications

1. Dispositif de montage sans outil de modules (13) au niveau d'un rail à chapeau (19) et de démontage non destructif et sans outil de ceux-ci, **caractérisé en ce qu'**il est réalisé sous forme d'un double ressort à branches (1) comportant un premier ressort à branches (2) et un second ressort à branches (3) qui sont disposés coaxialement par rapport à un axe de ressort commun (4), dans lequel, à une première extrémité du double ressort à branches (1), une extrémité de ressort du premier ressort à branches (2) forme une première branche de ressort (5) et une extrémité de ressort du second ressort à branches (3) forme une seconde branche de ressort (6), les première et la seconde branches de ressort (5, 6) ayant les mêmes dimensions et formant respectivement un crochet (7, 8) courbé en direction d'une autre seconde extrémité du double ressort à branches (1), le double ressort à branches (1) présentant à l'autre seconde extrémité une branche intermédiaire commune (9) qui constitue un crochet (10) courbé en direction de la première extrémité, les premier et second crochets (7, 8) dépassant à la première extrémité du double ressort à branches (1) et le crochet (10) formé à la seconde extrémité du double ressort à branches (1) à la seconde extrémité du double ressort à branches (1) dépassant d'un plan formé par les pièces droites (11, 12) se trouvant entre les ressorts à branches (2, 3) et la branche intermédiaire commune (9) du double ressort à branches (1), les deux ressorts à branches (2, 3) dépassant sur la face opposée de ce plan et les ressorts à branches (2, 3) étant réalisés de manière à ce que les crochets (7, 8), au niveau de la première extrémité du double ressort à branches (1) et le crochet (10) formé par la branche intermédiaire (9) puissent être écartés contre la force des ressorts à branches (2, 3), les deux ressorts à branches (2, 3) et les première et seconde branches de ressorts (5, 6) (2, 3) pouvant d'abord être passés respectivement avec les ressorts à branches (2, 3) dans des premier deuxième orifices (15, 16) pratiqués au niveau de la paroi de boîtier (14) tournée à l'état monté vers le rail à chapeau (19) du module (13) et les deux crochets (7, 8) formés par les premières et seconde branches de ressorts (5, 6) pouvant respectivement être accrochés dans des troisième et quatrième orifices (17, 18) pratiqués au niveau de la paroi de boîtier (14) tournée à l'état monté vers le rail à chapeau (14) du module (13) au-dessus des premier et deuxième orifices (15, 16) de la paroi de boîtier (14) détournée à l'état monté du rail à chapeau (14).

2. Dispositif de montage sans outil de modules (13) au niveau d'un rail à chapeau (19) et de démontage non destructif et sans outil de ceux-ci selon la revendication 1, **caractérisé en ce que** le double ressort à branches est fabriqué en acier à ressort (1) . z

3. Dispositif de montage sans outil de modules (13) au niveau d'un rail à chapeau (19) et de démontage non destructif et sans outil de ceux-ci selon la revendication 1 ou 2, comprenant les étapes suivantes :
fixation du double ressort à branches (1) au module à monter (13), les deux ressorts à branches (2, 3) et les premières et seconde branches de ressort (5, 6) étant d'abord respectivement passées avec les ressorts à branches (2, 3) dans un premier et deuxième orifice (15, 16) pratiqué sur la face tournée à l'état monté vers le rail à chapeau (19) de la paroi de boîtier (14) du module (13), les deux crochets (7, 8) constitués par les première et deuxième branches de ressort (5, 6) étant accrochés respectivement dans des troisième et quatrième orifices (17, 18) de la paroi de boîtier (14) tournée à l'état monté vers le rail à chapeau du module (13), vu à l'état monté, au-dessus des premier et deuxième orifices (15, 16) de la face détournée à l'état monté du rail à chapeau (19) de la paroi de boîtier (14), sachant que, après l'accrochage des crochets (7, 8) formés par les première et seconde branches de ressorts (5, 6), le crochet (10) formé par la branche intermédiaire (9) dépasse à l'état monté de la face tournée vers le rail à chapeau (19) de la paroi de boîtier (14) tournée à l'état monté vers le rail à chapeau (19) du module (13) ; et
pose du module (13) sur le rail à chapeau (19), en établissant d'abord une correspondance géométrique entre le crochet (10) formé par la branche intermédiaire (9) et l'extrémité inférieure (20) du rail à chapeau (19), sachant que, ensuite, le module (13) est tiré vers le haut contre la force des ressorts à branches (2, 3) et poussé en direction du rail à chapeau (19) jusqu'à ce qu'une saillie (22) dirigée vers le bas, c'est-à-dire courbée en direction de la branche intermédiaire (9) de la face tournée à l'état monté vers le rail chapeau (19) de la paroi de boîtier (14) tournée à l'état monté vers le rail à chapeau (19) du module (13) établisse avec l'extrémité supérieure (21) du rail à chapeau (19) une liaison par correspondance géométrique, le module (13) étant tiré vers le bas par la force des ressorts à branches (2, 3), de sorte que la liaison par correspondance géométrique entre la saillie (22) et l'extrémité supérieure (21) du rail à chapeau (19) ne peut pas être suspendue sans intervention extérieure ciblée, ce qui fait que le module (13) est monté au niveau du rail à chapeau (19).
